# EUROPÄISCHE PATENTSCHRIFT

(11) **EP 2 209 927 B1**
(45) Veröffentlichungstag und Bekanntmachung des Hinweises auf die Patenterteilung: **08.02.2012**
(21) Anmeldenummer: 08850790.0
(22) Anmeldetag: 06.11.2008
(51) Int. Cl.: C23C 16/26, C23C 14/06, F16C 33/12

(54) **KORROSIONSFESTE BESCHICHTUNG**
CORROSION-RESISTANT COATING
REVÊTEMENT RÉSISTANT À LA CORROSION

(30) Priorität: 14.11.2007 DE 102007054181
(43) Veröffentlichungstag der Anmeldung: 28.07.2010
(60) Teilanmeldung: 10178555.8
(73) Patentinhaber: Schaeffler Technologies GmbH & Co. KG, 91074 Herzogenaurach (DE)
(72) Erfinder: HOSENFELDT, Tim Matthias, 96106 Ebern (DE); HAAG, Bertram, 91486 Uhlfeld (DE); MUSAYEV, Yashar, 90419 Nürnberg (DE)
(86) Internationale Anmeldenummer: PCT/EP2008/065046
(87) Internationale Veröffentlichungsnummer: WO 2009/062877

(56) Entgegenhaltungen:
- EP-A- 1 114 881
- WO-A-2007/020139
- WO-A-2007/028791
- WO-A-2008/000573
- JP-A- 2005 330 556
- US-A1- 2004 137 207
- US-A1- 2006 105 171

## Beschreibung

Die Erfindung betrifft eine amorphen Kohlenstoff aufweisende Beschichtung nach dem Oberbegriff des Anspruchs 1. eine derartige Beschichtung ist beispielweise aus der US 2004/0137207 A1 bekannt.

Die Erfindung liegt auf dem Gebiet der Tribologie und bezieht sich auf die Beschichtung von Maschinenteilen zur Verringerung der Reibungsverluste und des Verschleißes durch mechanische und korrosive Einflüsse, insbesondere in aggressiven Umgebungen. Die vorliegende Erfindung ist grundsätzlich auf viele verschiedenartige Maschinenteile anwendbar, die tribologischen Beanspruchungen einschließlich chemisch aggressiven Einflüssen ausgesetzt sind. Als besonders vorteilhaftes Beispiel wird jedoch die Verwendung bei Wälzlagern und Teilen von Verbrennungskraftmaschinen, insbesondere bei Ventittriebkomponenten herangezogen. Eine Anwendung bei industrieller Verwendung wie beispielsweise in Windkraftanlagen, in Linearführungen oder in sonstigen Lagerkomponenten ist ebenfalls denkbar.

Grundsätzlich werden die Anforderungen an derartige Komponenten durch Steigerung von mechanischen Belastungen, Bewegungsgeschwindigkeiten und Standzeiten immer höher. Dabei wird zunehmend geringere Wartungsintensität vorausgesetzt. Entsprechende Schmierstoffe werden wegen der steigenden Anforderungen an die Umweltverträglichkeit mit immer weniger Additiven verwendet und der Trend geht teilweise zu niederviskosen Schmierstoffen oder sogar zum Betrieb ohne Schmierstoffe.

Zudem ergeben sich zunehmend Anwendungen für derartige, triblologisch belastete Bauteile, bei denen diese unmittelbar einem Fluid ausgesetzt ist, das den tribologischen Anforderungen nicht förderlich ist, wie beispielsweise bei Geräten zur Förderung aggressiver flüssiger Medien, wie Kraftstoffpumpen und dergleichen oder bei Bauteilen, die mit Lebensmitteln oder Wasser, insbesondere Salzwasser oder Salznebel in Kontakt kommen.

Daher gewinnt die individuelle beanspruchungsgerechte Gestaltung von tribologischen Schichten an Bedeutung, wobei zusätzlich zu den mechanischen Beanspruchungen auch dem Angriff durch chemische Korrosion Widerstand entgegengesetzt werden muss.

Bereits die entsprechenden Anforderungen an die mechanischen Eigenschaften wie niedrige Reibungskräfte und Adhäsion sowohl im flüssigkeitsgeschmierten, als auch im trockenen und im Übergangsbereich, an niedrige Adhäsionskräfte, hohen Verschleißwiderstand und gleichzeitig Zähigkeit gegenüber Stoßbelastungen sowie die Widerstandsfähigkeit gegen Abplatzen werden durch konventionelle Beschichtungen nicht mehr erfüllt.

Teilweise können einzelne der Anforderungen durch in bestimmter Weise geartete Beschichtungen erfüllt werden, wie beispielsweise die Härte oder der geringe Reibwiderstand, jedoch leiden regelmäßig andere Eigenschaften des tribologischen Systems, wie beispielsweise auch die Stabilität gegenüber chemischer oder elektrochemischer Korrosion.

Besonders deutlich werden die vielfältigen Anforderungen beispielsweise bei Betrachtung eines Wälzlagers, das für einen Pumpenantrieb für eine chemisch aktive Flüssigkeit, zum Beispiel Kraftstoff, eingesetzt wird.
Das Lager muss bei niedriger Reibung und geringem Abrieb zumindest auch gegenüber dem entsprechenden Treibstoff chemisch langzeitstabil sein.

Die Anforderungen werden auch am Beispiel von Ventiltrieben bei Verbrennungskraftmaschinen deutlich, bei denen das Augenmerk insbesondere auf Nockenstößelvorrichtungen liegt.

Derartige Nockenstößelvorrichtungen sind beispielsweise in Kraftfahrzeugmotoren mit hin- und hergehenden Kolben eingebaut, welche Lufteinlass- und Luftauslassventile aufweisen, die sich in Phase mit der Drehung der Kurbelwelle oder synchron hierzu öffnen und schließen. Ein Ventilantriebsmechanismus wird zur Übertragung der Bewegung des an der Nockenwelle angebrachten Nockens auf die Ventile verwendet, wenn sich die Nockenwelle zusammen mit der Kurbelwelle des Motors dreht. Dabei gelangt der Nocken der Nockenwelle in Reibkontakt mit einer Lauffläche des zugeordneten Tassenstößels.

Gemäß dem Stand der Technik ist es bereits bekannt, Laufflächen von reibendem Verschleiß ausgesetzten Maschinenteilen mit Verschleißschutzschichten zu versehen, die je nach Anwendungsfall bevorzugt aus galvanisch aufgetragenen Metallen oder aus in einem thermischen Spritzverfahren aufgetragenen Metallen und/oder Metalllegierungen gegebenenfalls mit Hartstoffzusätzen bestehen.

Hierbei hat sich jedoch die Tatsache als nachteilig herausgestellt, dass thermisch aufgespritzte Metallschichten eine relativ schwache Festigkeit besitzen, und es ist daher bekannt, zur Verbesserung der Festigkeit die Metallschichten nach dem Auftrag beispielsweise durch Plasmastrahlen, Laserstrahlen, Elektronenstrahlen oder durch einen Lichtbogen derart umzuschmelzen, dass sich die Spritzwerkstoffe mit dem dabei gleichzeitig im Oberflächenbereich aufgeschmolzenen Grundwerkstoff schmelzflüssig vermischen und legieren. Darüber hinaus müssen die thermisch aufgespritzten und somit rauhen Beschichtungen mechanisch nachgearbeitet werden um gute trobologische Eigenschaften aufzuweisen. Beim Umschmelzlegieren entstehen jedoch inhomogene Zonen unterschiedlicher Zusammensetzung, in denen sowohl der Grundwerkstoff als auch das Schichtmaterial überwiegen kann. Bei zu hohem Grundmaterialanteil ist der Schichtverschleiß dann zu hoch, und bei geringem Grundmaterialanteil besteht bei verschiedenen Schichtkombinationen die Gefahr von Makrorissbildungen, die schon für sich zum Verlust des Korrosionsschutzes führen, sodass solche Schichten in aggressiven Umgebungen nicht einsetzbar sind. In einem derartigen Fall können Reibungsbelastungen zudem einen unerwünschten Adhäsiv-Verschleiß an den Schichten verursachen.

Ferner ist es bekannt, die Lauffläche von belasteten Bauteilen, auch von Tassenstößeln, mittels eines thermochemischen Prozesses zu carbonitrieren und/oder zu nitrocarburieren. Dabei hat sich jedoch als nachteilig herausgestellt, dass kein zufriedenstellender Reibungskoeffizient erreicht wird und ein zu geringer Verschleißwiderstand entsteht.

Außerdem ist bekannt, die Lauffläche des Stößels mit einer Manganphosphatschicht oder einem Gleitlack zu beschichten. Auch hierbei werden keine zufriedenstellenden Reibungskoeffizienten und Verschleißwiderstände erreicht. Zudem wird durch derartige Materialien die Umwelt unnötig belastet. Dasselbe gilt für galvanische Schichten, die ebenfalls auf den Laufflächen aufgebracht werden können.

Es sind aus dem Stand der Technik als Beschichtungsmaterialien auch Hartmetalle und Schnellarbeitstähle (ASP 23) bekannt, die jedoch neben einem nicht zufriedenstellenden Reibungskoeffizienten und einem nicht zufriedenstellenden Verschleißwiderstand zusätzlich eine nachteilig hohe Masse aufweisen. Zudem zeichnen sich die wirklich korrosionsbeständigen Stähle durch hohe Kosten aus

Es ist außerdem der Korrosionsschutz durch Vernickeln bekannt, der seine Wirkung jedoch erst ab einer Schichtstärke von ca. 15-20 Mikrometern gewährleistet, was zum Verlust von Konturgenauigkeiten und der Passgenauigkeit führen kann.

Es kann auch eine Hartchrom- Beschichtung verwendet werden, die jedoch die Korrosion nur vermindert und nicht vollständig verhindern kann, da sie die Bildung von Mikrorissen und damit einen Angriff auf das beschichtete Material zulässt.
Außerdem sind harte, mittels beispielsweise eines PVD- oder eines (PA)CVD-Verfahrens, hergestellte Schichten, wie beispielsweise TiN, CrN, (Ti, Al)N, bekannt. Es zeigt sich jedoch, dass die Herstellung geschlossener, porenfreier Schichten mit den genannten Stoffen sehr schwierig ist. Nachteilig an der Verwendung der genannten Stoffe hat sich zudem die Tatsache herausgestellt, dass diese Schichten einen hohen Verschleiß des Gegenkörpers zur Folge haben, falls diese Schichten nicht nachbearbeitet werden. Im Falle einer Nachbearbeitung ergeben sich undefinierte Oberflächenzustände aufgrund der reaktiven Oberflächen.

Aus dem US-Patent 5,237,967 sind kohlenstoffbasierte PVD- und (PA)CVD-Schichten mit 20 bis 60 Atom-% Wasserstoff in der Deckschicht bekannt, sogenannte metallhaltige Kohlenwasserstoffschichten (a-C:H:Me) und amorphe Kohlenwasserstoffschichten (a-C:H). Diese Schichten weisen jedoch einen relativ geringen Verschleiß- und Ermüdungswiderstand auf und sind deshalb für hoch beanspruchte Bauteile in neuen Motorengenerationen nicht ohne weiteres geeignet und bieten eine vergleichsweise geringe Reibungsreduzierung im Betrieb.

Um die gewünschte optimale Oberflächenstruktur eines Bauteils über die gesamte Lebensdauer zu erhalten, ist es notwendig, die Oberfläche so zu gestalten, dass sie einen hohen Verschleißwiderstand, eine geringe adhäsive Neigung zum Gegenkörper und geringe Reaktivität zur Umgebung aufweist. Ferner darf die Oberfläche vorzugsweise keine abrasiven Partikel, wie Droplets, enthalten.

Auch Bauteile aus Eisen/Kohlenstofflegierungen, auch im wärmebehandelten Zustand, wie carbonitriert, nitrocarburiert oder nitriert, erreichen nicht die gewünschten Verschleißwiderstände und tribologisch günstigen Oberflächenzustände. Behandelt man beispielsweise Nitridschichten, insbesondere durch (Fein)Schleifen, Läppen, Polieren, Strahlen, etc., mechanisch nach, so werden neben der Oberflächenstruktur auch die chemische Zusammensetzung und Reaktivität der Oberfläche verändert. Diese Veränderungen sind zum einen großen Streuungen unterworfen, wodurch keine gleich bleibende Qualität realisiert werden kann. Zum anderen weisen topographisch affine Oberflächen ungünstigere tribologische Eigenschaften auf und neigen zu Adhäsionen mit dem Gegenkörper. Ferner werden durch Schleif- und Polierprozesse Druckeigenspannungen in den oberflächennahen Bereichen induziert, welche sich zu den bereits vorhandenen hohen Druckeigenspannungen der Hartstoffschicht addieren.

Zusätzlich führen die induzierten Versetzungen und die herausgerissenen Droplets zu Fehlstellen und Mikrorissen, sodass die lokale Dauerfestigkeit der Schicht reduziert und die Haftfestigkeit bis hin zum möglichen Abplatzen beim Nachbearbeiten der Schicht herabgesetzt wird.

Werden Schutzschichten durch Plasma- Verfahren wie z.B. Plasma- Nitrieren oder PVD-arc- Beschichtungsverfahren aufgebracht, so ist auch eine zu hohe Prozesstemperatur oberhalb von 400 Grad zu befürchten, durch die die Härte des Grundmaterials verloren geht und Maßhaltigkeitsprobleme entstehen können.

Somit liegt der vorliegenden Erfindung die Aufgabe zugrunde, eine Beschichtung sowie ein Herstellungsverfahren für eine derartige Beschichtung zu schaffen, welche die oben genannten Nachteile beseitigen, insbesondere gegen Korrosion schützen sowie bei optimierten Reibwerten die Standzeit des beschichteten Maschinenteils sowie des Gegenkörpers erhöhen.

Die Aufgabe wird gemäß der Erfindung gelöst durch eine Beschichtung für ein Bauteil mit einer auf amorphem Kohlenstoff basierenden und Wasserstoff enthaltenden Funktionsschicht, wobei die Funktionsschicht eine Mehrzahl von Schichten enthält, die einen amorphen Kohlenstoff mit Wasserstoff aufweisen, die mit einem Nichtmetall dotiert sind und keine Metalldotierung aufweisen und von denen wenigstens eine Schicht dünner als 20 Nanometer ist und die sich entweder in einem die Kristallbildung beeinflussenden Merkmal unterscheiden oder zwischen denen jeweils wenigstens eine Schicht aus einem nicht mit einem Nichtmetall dotierten Kohlenstoff mit Wasserstoff liegt.

Die auf einem amorphen Kohlenstoff und Wasserstoff basierenden Funktionsschichten weisen durchwegs gute tribologische Eigenschaften auf, wobei sie zur Anpassung an spezielle Anforderungen in einer großen Bandbreite durch Einstellungen einzelner Parameter und Dotierungen anpassbar sind. Dadurch kann mit einfachen Mitteln versucht werden, die Anforderung an die Härte, die Verschleißfestigkeit, die Oberflächenglätte, Standfestigkeit und einen geringen Reibungskoeffizienten sowie die Adhäsionsneigung und die Verträglichkeit für schmiermittelfreie Reibung oder gering geschmierte Reibung zu vergrößern und auch den Betrieb lediglich mit Wasser als Schmierfluid zu ermöglichen.

Dabei können entsprechende Gestaltungen der Schichten besonders einfach im PVD- (physical vapour deposition) oder im PACVD- (Plasma assisted chemical vapour deposition) Verfahren aufgebracht und während dieses Verfahrens durch Einstellung der Prozessparameter besonders gut und einfach angepasst werden.

Als besonders vorteilhaft haben sich insbesondere zur Erhöhung der Korrosionsbeständigkeit Schichten gezeigt, die aus amorphem Kohlenstoff mit Wasserstoff und einer Dotierung aus Nichtmetallatomen bestehen.

Eine solche Dotierung mit Nichtmetallatomen erzeugt eine relativ zähe, weiche Schicht, die eine hohe Überrollfestigkeit aufweist und nicht zur Bildung von Abplatzungen und Mikrorissen neigt, durch die gegebenenfalls aggressive, Korrosion hervorrufende Fluide eindringen könnten.

Der Nichtmetalle enthaltende wasserstoffhaltige Kohlenstoff hat zudem die Eigenschaft, Reibungskräfte zu vermindern und, wenn beispielsweise Fluor, Silizium oder Sauerstoff eingelagert wird, auch die Eigenschaft, eine geringe Benetzbarkeit mit Schmierstoffen zu begünstigen. Dadurch wird ein dünnerer Ölfilm begünstigt, was insbesondere bei schnellen Relativbewegungen der Reibpartner, also zum Beispiel bei Ventiltrieben, Vorteile bringt.

Ein weiteres Erfordernis bei der Schichtbildung ist, dass keine größeren Kristallite gebildet werden, da an den sich einstellenden Korngrenzen entlang aggressive Substanzen Angriffsflächen finden könnten.

Aus diesem Grund wird eine Schichtbildung mit geringer Schichtdicke, insbesondere einer Schichtdicke unter 20 nm angestrebt, wobei Schichten unterschiedlicher Konsistenz benachbart sind und damit Kristalite sich nicht über mehrere Schichten erstrecken.

Dies kann einerseits dadurch erreicht werden, dass beispielsweise nicht mit einem Nichtmetall dotierte Schichten auf der Basis eines amorphen Kohlenstoffs und Wasserstoffs mit den dotierten Schichten abwechseln oder dass direkt einander benachbarte Schichten sich in einem für die Kristallbildung wichtigen Merkmal unterscheiden, nämlich dem Dotierungsgrad, dem Wasserstoffanteil, dem Anteil der SP3-hybridisierten Atome oder der Art der Dotierungsatome. Auf diese Weise sind in benachbarten Schichten niemals gleiche Verhältnisse für ein Kristallwachstum gegeben, so dass entsprechend in einer Schicht sich ausbildende Kristalle nicht in der nächsten Schicht fortgesetzt werden. Schichten unterschiedlicher Konsistenz können auch durch stetigen Übergang der variablen Materialparameter, wie beispielsweise die Dotierungsdichte, aneinander angeschlossen werden.

Die grundsätzlichen tribologischen und kristallbildenden Eigenschaften werden beispielsweise durch den Wasserstoffanteil im Kohlenstoff als Materialparameter stark mitbestimmt. Wasserstoffanteile unter 20 % insbesondere zwischen 5 % und 20 %, machen den wasserstoffhaltigen amorphen Kohlenstoff tendenziell härter.

Auch das prozentuale Verhältnis von sp³- und sp²-hybridisierten Kohlenstoff kann zwei benachbarte Schichten voreinander unterscheiden. Es betrifft dies den Kohlenstoff, der in Diamant- und Graphitmodifikation vorliegt, die bekanntermaßen unterschiedliche mechanische Eigenschaften aufweisen. Dementsprechend haben die derart unterschiedlichen benachbarten Schichten auch verschiedene tribologische Eigenschaften. Besonders vorteilhaft ist dabei, wenn der Anteil der sp³⁻hybridisierten C-Atome größer als 50 % der C-Atome ist.

Als Dotierungsatome der nichtmetalldotierten Schicht können beispielsweise Fluor, Sauerstoff oder besonders vorteilhaft Silizium eingesetzt werden. Insbesondere das Einlagern von Silizium erhöht die Oxidationsbeständigkeit und führt zur Ausbildung einer besonders dichten Schicht. Wird die oberste Laufschicht mit Silizium dotiert, so wird auch beispielsweise eine Schmierung nur mit Wasser ermöglicht. Im unteren Bereich der Funktionsschicht, der nicht direkt dem Angriff von korrodierenden Materialien ausgesetzt ist, können durchaus auch metalldotierte Schichten eingesetzt werden, die eine erhöhte Zähigkeit erzeugen.

Es ist dann davon auszugehen, dass eventuell angreifende Korrosionsstoffe nicht bis zu den metalldotierten Schichten gelangen.

Zur Erzeugung einer optimierten Schichtstruktur kann vorteilhaft wenigstens eine nichtmetalldotierte Schicht einer undotierten Schicht benachbart sein. Es können sich auch bereichsweise nichtmetalldotierte und undotierte Schichten abwechseln. Dabei können Bereiche mit fünf, vorteilhaft zehn oder auch mindestens zwanzig nichtmetalldotierte und nicht mit einem Nichtmetall dotierte Schichten abwechselnd vorgesehen sein. Hierdurch werden die gesamtmechanischen Eigenschaften der Funktionsschicht positiv beeinflusst, da die jeweils einzeln dünnen Schichten mit unterschiedlichen Eigenschaften miteinander gekoppelt sind.

Dadurch ergibt sich beispielsweise in der Abwechselung von weichen und etwas härteren Schichten ein sehr widerstandsfähiger Gesamtaufbau, wobei die weichen nichtmetalldotierten Schichten jeweils für die Blockierung des Eindringens von Korrosion erzeugenden Stoffen sorgen. Teilweise üben die Dotierungen einer Schicht auch eine gewisse Fernwirkung auf die benachbarte Schicht durch die sich mitteilende Schichtstruktur aus. Daraus ergibt sich, dass eine große Anzahl von dünnen, abwechselnden Schichten, die beispielsweise zu einem großen Teil dünner als 20 nm sind, sehr gute Ergebnisse erzielt.

Zudem kann vorteilhaft vorgesehen sein, dass wenigstens eine der nichtmetalldotierten Schichten einen Gradienten der Dotierungsdichte senkrecht zur Oberfläche aufweist.

Durch eine derart variierende Dotierung ergibt sich eine weitere Senkung der Neigung zur Kristallbildung, wodurch Angriffspunkte für aggressive, die Korrosion fördernde Stoffe noch seltener geboten werden.

Idealerweise wird der Gradient der Dotierung dabei so ausgerichtet, dass, insbesondere bei der Dotierung mit Silizium, die härteren Schichtbestandteile näher an der tribologisch beanspruchten Oberfläche der Funktionsschicht liegen, dass also die Dotierungsdichte dorthin zunimmt.

Die Erfindung bezieht sich zudem auf eine Beschichtung für ein Bauteil mit einer auf amorphem Kohlenstoff und Wasserstoff basierenden Funktionsschicht, bei der die Funktionsschicht wenigstens eine Teilschicht enthält, die mit einem Nichtmetall dotiert ist und kein Metall enthält, wobei die Dotierungsdichte über die Dicke der Teilschicht einen Gradienten aufweist.

Es zeigt sich, dass auch einzelne nichtmetalldotierte Schichten auf der Basis von amorphem Kohlenstoff und Wasserstoff bei guten mechanischen Eigenschaften korrosionshemmend wirken können, wenn ein geeigneter Gradient der Dotierungsdichte vorgesehen wird, der die Ausbildung von schichtüberbrückenden Strukturen, insbesondere Kristalliten verhindert. Dabei werden solche Schichten vorteilhaft metallfrei gehalten, da Metalldotierungen Angriffspunkte für die Korrosion bilden können. Eine derartige Schicht kann vorteilhaft dicker als 10 nm, insbesondere dicker als 50 nm, besonders vorteilhaft dicker als 100 nm sein.

Vorteilhaft weist die Beschichtung unterhalb der Funktionsschicht wenigstens eine Haftvermittlungsschicht auf, die aus Chrom, Wolfram oder Titan oder aus Boriden, Karbiden oder Nitriden der Übergangsmetalle besteht. Ein derartiger Haftvermittler stabilisiert den Gesamtaufbau aus dem beschichteten Maschinenteil mit der Funktionsschicht und verhindert insbesondere Ablösungen der Funktionsschicht. Als für die Maschinenteile geeignete Materialien kommen übliche leicht verarbeitbare und kostengünstige Werkstoffe (16Mn Cr5, C45, 100 Cr6, 31 Cr Mo V9, 80 Cr2 und so weiter) in Frage. Als Reibpartner sind im Sinne eines Leichtbaus zur Gewichtseinsparung auch Eisen/Kohlenstofflegierungen denkbar.

Besonders vorteilhaft ist auch das Vorsehen einer Stützschicht unterhalb der Funktionsschicht aus einer metallhaltigen oder nichtmetallhaltigen, Wasserstoff enthaltenden Kohlenstoffschicht, die eine oder mehrere der Komponenten Wolfram, Tantal, Chrom, Vanadium, Hafnium, Titan, Molibden, Kupfer, Zirkonium oder Nickel einerseits oder Silizium, Sauerstoff, Fluor, Stickstoff andererseits enthält.

Eine derartige Stützschicht hat die Aufgabe, große mechanische Kraftbelastungen, die auf die Funktionsschicht wirken, abzufangen, so dass keine übermäßige Verformung der Funktionsschicht eintritt, die zur Ablösung von Untergründen oder zur Zerstörung der Funktionsschicht durch Rissbildung und Abplatzen führen könnte. Die Zwischenschicht ist extrem fest, wobei sie weder einen geringen Reibungswiderstand noch Verschleißfestigkeit aufweisen muss. Daher kann die Stützschicht gezielt so gestaltet werden, dass sie eine geringe Nachgiebigkeit aufweist beziehungsweise in der Nachgiebigkeit derart eingestellt wird, dass sie einen optimalen Übergang zwischen der Funktionsschicht und dem eigentlichen Maschinenteil schafft.

Ferner bezieht sich die Erfindung auf ein Verfahren zur Herstellung einer Beschichtung mit den beschriebenen Merkmalen, bei dem in einem Abscheideverfahren zum Aufbringen der Funktionsschicht auf die Oberfläche eines Bauteils in bestimmten zeitlichen Abständen jeweils wenigstens ein Prozessparameter derart geändert wird, dass die gewünschten Schichtdicken unterschiedlicher Teilschichten sowie gegebenenfalls entsprechende Gradienten von Dotierungen entstehen, sowie auf ein Beschichtungsverfahren bei dem wenigstens einer der Parameter, Druck, Temperatur, Beimengungen von Dotierungsstoffen, Wasserstoffgehalt, Rotationsgeschwindigkeit des zu beschichtenden Bauteils während der Herstellung der Funktionsschicht mehrfach sprunghaft geändert wird.

Beim Abscheidevorgang wie auch bei eventuellen anderen Schritten der Beschichtung wie zum Beispiel Ausheizen oder Plasmaätzen wird eine Verfahrenstemperatur von 250° C vorteilhaft nicht überschritten, da damit die Härtung des Grundmaterials des Maschinenteils erhalten bleibt und eine Nachbearbeitung beispielsweise durch induktives Härten nicht erfolgen muss. Eine mechanische Nachbearbeitung der Schicht, wie z. B. Polieren, Schleifen, etc. und Designänderung ist ebenso nicht notwendig.

Die Abscheidung erfolgt vorteilhaft im Rahmen bekannter PVD (physical vapour deposition) und (PA)CVD (plasma assisted chemical vapour deposition)-Verfahren.

Bei einem PVD-Verfahren wird ein Ausgangsmaterial, beispielsweise Graphit, derart zerstäubt (gesputtert), dass ein Strahl hochenergetischer Kohlenstoff-Ionen aus dem Graphit emitiert und in Richtung der zu beschichtenden Oberfläche in einem Feld beschleunigt wird.

Bei einem (PA)CVD-Verfahren wird unter Zuhilfenahme eines Plasmas ein Gasgemisch in die Prozesskammer eingebracht, in welcher sich die zu beschichtenden Materialteile befinden. Das (PA) CVD-Verfahren ist eine Weiterentwicklung des CVD-Verfahrens und kombiniert die Vorteile des CVD-Verfahrens (ungerichteter Prozess) und des PVD-Verfahrens (niedrige Temperaturen). Beim PACVD-Verfahren erfolgt die Schichtabscheidung durch chemische Reaktion aus der Gasphase bei Temperaturen von weniger als 200° C mit einer gezielten Plasma-Unterstützung.

Durch die Änderung der Prozessparameter wie Druck, Temperatur und Wasserstoffgehalt sowie Dotierungsstoffe oder die Rotationsgeschwindigkeit des zu beschichtenden Gegenstandes wird die Struktur der entstehenden Beschichtung bestimmt. Dabei ergeben sich bei bestimmten Parametergrenzen auch sprunghafte Änderungen in der Konsistenz der abgeschiedenen Schicht, da bestimmte insbesondere kristalline Konfigurationen nur bis zu bestimmten Materialanteilen einzelner Stoffe gebildet werden können. Liegen diese Anteile nicht vor, so wird ein anderer Kristall oder eine andere Modifikation beziehungsweise eine Mischphase gebildet.

Ferner bezieht sich die Erfindung auf ein Kugellager mit einer Beschichtung wie oben beschrieben. Das Kugellager kann ein- oder mehrreihig ausgebildet sein und ist beispielsweise in einer Werkzeugmaschine oder in einer Windkraftanlage verwendbar. Ein erfindungsgemäß beschichtetes Wälzlager kann als Wälzkörper statt Kugeln beispielsweise auch Zylinderrollen, Nadeln, Kegelrollen, Tonnenrollen oder Kugelrollen aufweisen. Als Beispiel von Wälzlagern mit erfindungsgemäßer Beschichtung sind Axialzylinderrollenlager sowie Schrägkugellager zu nennen.

Die Erfindung wird im Folgenden anhand mehrerer Ausführungsbeispiele nämlich eines Ventiltriebs sowie zweier Lagervorrichtungen, in einer Zeichnung gezeigt und anschließend beschrieben.

Dabei zeigen:
- Figur 1: eine Vorderansicht einer Reibpaarung, bestehend aus Tassenstößel und Nockenwelle für den Betrieb eines Ventils einer Brennkraftmaschine;
- Figur 2: eine perspektivische Ansicht des Tassenstößels aus Figur 1;
- Figur 3: eine perspektivische Ansicht eines hydraulischen Abstützelementes, welches über eine Wälzlagerkomponente mit einem Schlepphebel in Verbindung steht;
- Figur 4: eine schematische Querschnittsansicht eines Maschinenteils mit verschleißfester Beschichtung gemäß einem Ausführungsbeispiel der vorliegenden Erfindung,
- Figur 5: eine erfindungsgemäße Beschichtung im Detail im Querschnitt;
- Figur 6: ein einreihiges Wälzlager mit einer erfindungsgemäßen Beschichtung und
- Figur 7: ein zweireihiges Wälzlager mit einer erfindungemäßen Beschichtung.

In den Figuren der Zeichnung bezeichnen gleiche Bezugszeichen gleiche oder funktionsgleiche Komponenten, soweit nichts Gegenteiliges angegeben ist.

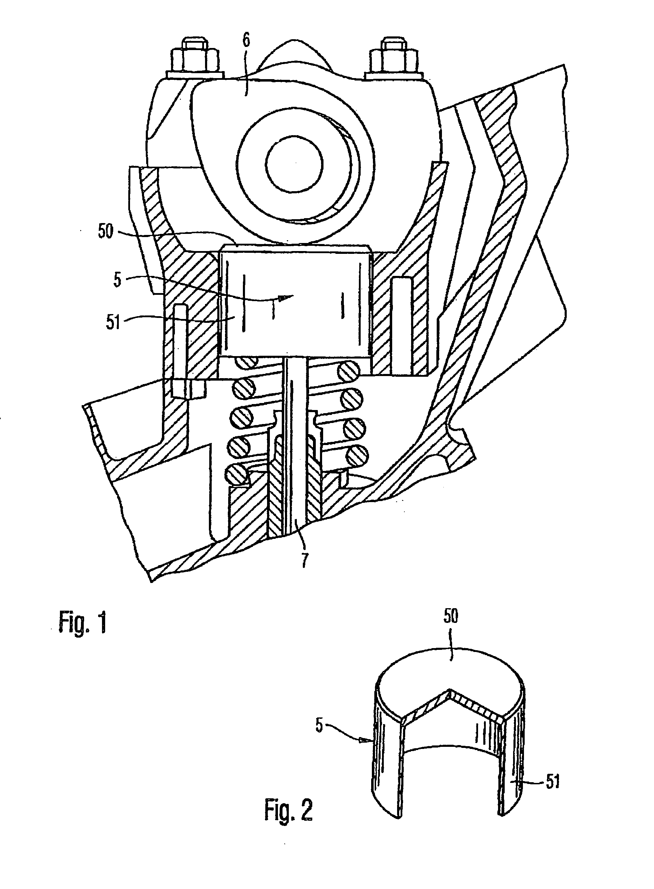

Fig. 1 illustriert eine Reibpaarung, bestehend aus einem Tassenstößel 5 mit einer Nockenkontaktfläche 50 und einem Tassenhemd 51 sowie aus einer Nocke 6. Der Tassenstößel 5 ist in Fig. 2 in einer perspektivischen Ansicht detaillierter dargestellt. Der Tassenstößel 5 ist im Allgemeinen für Maschinenteile in Brennkraftmaschinen mit dem Schaft 7 eines Ventils verbunden, welches durch Verschieben der Nockenfläche gegen die Nockenkontaktfläche 50 des Tassenstößels 5 das Ventil öffnet oder schließt.

Im Allgemeinen unterliegen moderne Ventiltriebkomponenten, wie beispielsweise Tassen- und Pumpenstößel, hohen Anforderungen bezüglich des Verschleißwiderstandes und der Korrosion, insbesondere an der Kontaktfläche 50.

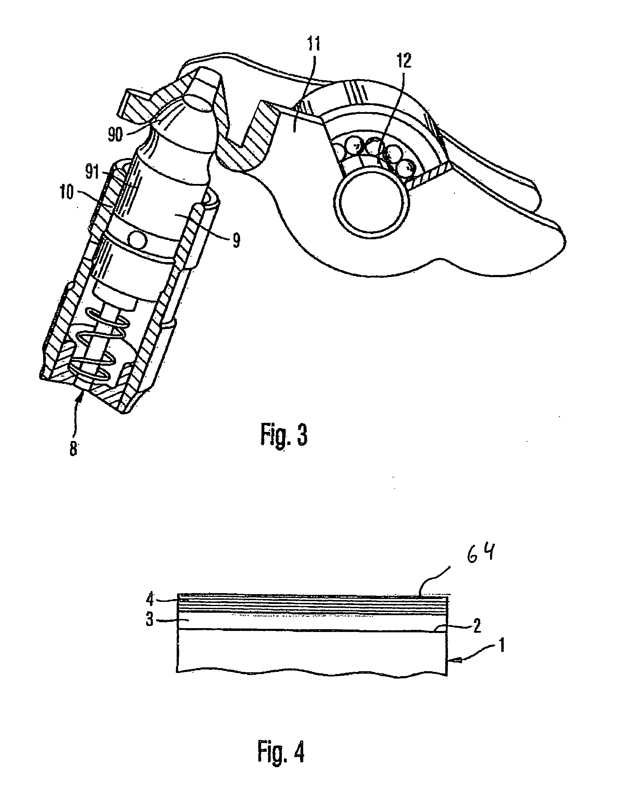

In Verbindung mit Fig. 4, welche eine schematische Querschnittsansicht einer verschleißfesten Beschichtung für ein Maschinenteil 1, beispielsweise für einen Tassenstößel 5, oder eine Wälzlagerkomponente gemäß einem bevorzugten Ausführungsbeispiel der vorliegenden Erfindung illustriert, wird die vorliegende Erfindung im folgenden näher erläutert.

Der Tassenstößel 5 wird für eine Reduzierung des Reibungskoeffizienten und für eine Erhöhung des Verschleißwiderstandes im Bereich der Nockenkontaktfläche 50 oder bei Bedarf im Bereich der Nockenkontaktfläche 50 und des Tassenhemdes 51 mit einer erfindungsgemäßen verschleißfesten und korrosionsbeständigen Beschichtung versehen. Im Falle starker Verformungen des Tassenhemdes 51 des Tassenstößels 50 im Bereich der offenen Seite, kann wahlweise auch eine Teilbeschichtung des Tassenhemdes 51 erfolgen. Entsprechend können auch Teile eines Wälzlagers wie die Wälzkörper, oder ein Innen- oder Außenring ganz oder teilweise beschichtet werden.

Die zu beschichtende Fläche 2 wird vorzugsweise vor einem Beschichten einsatzgehärtet oder carbonitriert und angelassen.

Der Grundkörper, welcher vorteilhaft aus einem kostengünstigen Stahlwerkstoff, wie beispielsweise 16MnCr5, C45, 100Cr6, 31CrMoV9, 80Cr2 oder dergleichen, besteht, wird gemäß dem vorliegenden Ausführungsbeispiel zunächst mit einer Haftvermittlungsschicht 3 beschichtet. Die Haftvermittlungsschicht 3 kann beispielsweise jeweils aus einem metallhaltigen Kohlenstoff, einer Verbindung aus Wolfram und Kohlenstoff, aber auch aus metallischen Stoffen (z.B. Cr, Ti), sowie Boriden, Carbiden, Nitriden und Siliziden der Übergangsmetalle bestehen. Eine zusätzliche Stützschicht oberhalb der Haftvermittlungsschicht kann aus einem ein Metall oder Nichtmetall wie beispielsweise W, Ta, Cr, V, Hf, Ti, Ni, Mo, Cu, Zr oder Si, O, F, N sowie Wasserstoff enthaltenden amorphen Kohlenstoff bestehen.

Die Haftvermittlungs- und die Stützschicht können im Zusammenhang mit einer Wärmebehandlung, beispielsweise Einsatzhärten, Carbonitrieren, Nitrocarburieren, durch ein thermochemisches Verfahren, beispielsweise Nitrieren, Borieren, durch ein galvanisches Verfahren, beispielsweise durch Aufbringen einer chromhaltigen Schicht, oder mittels eines PVD-Verfahrens, beispielsweise Aufbringen von Me-C, Carbiden und Nitriden der Übergangsmetalle, gebildet werden.

Durch die Stützschicht soll die Ermüdungsfestigkeit der Gesamtbeschichtung erhöht, d.h. plastische Verformungen, Rissbildungen, -wachstum und Brüche des Schichtsystems verhindert werden. Derartige Ermüdungsvorgänge können durch die Belastung und die daraus induzierte Materialbeanspruchung sowie durch unterschiedliche Härtegrade, Elastizitätsmodule und Verformbarkeiten der einzelnen Schichten bzw. des Grundkörpers und der verschleißfesten Beschichtung entstehen. In diesem Fall ist eine Ausbildung der Schicht 3 als Stützschicht entweder alleine oder in Kombination mit einer geeigneten Haftvermittlungsschicht vorzuziehen.

Wie in Fig. 4 dargestellt, ist gemäß dem vorliegenden Ausführungsbeispiel über der Stütz- und/oder der Haftvermittlungsschicht 3 eine verschleiß- und korrosionsfeste Funktionsschicht 4 gebildet.

Die Funktionsschicht 4 ist dort schematisch als aus vielen einzelnen Nanoschichten aufgebaut gezeigt, wobei die Größenverhältnisse nur schematisch und nicht maßstäblich wiedergegeben sind.

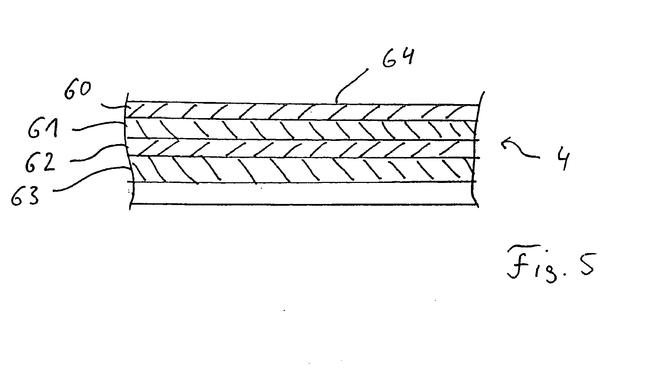

In der Figur 5 ist die Funktionsschicht maßstäblich stark vergrößert dargestellt.

Der Maßstab ist wegen der geringen Dicke der Nanoschichten in Richtung senkrecht zur Oberfläche 64 weit auseinandergezogen. Die einzelnen Schichten 60, 61, 62,63 sind zumindest im oberen Bereich zur Oberfläche hin unterschiedlich schraffiert und dadurch unterscheidbar.
Die einzelnen Schichten unterscheiden sich wenigstens teilweise in Bezug auf die Konsistenz, das heißt beispielsweise die Nichtmetalldotierung, den Wasserstoffanteil, die Art und Menge der zugesetzten, eindotierten Stoffe beziehungsweise Kristallmodifikationen und -orientierungen.

Die Erfindung stellt außerdem ein einfaches Herstellungsverfahren für eine derartige Funktionsschicht bereit, das gegenüber den bisher verwendeten Produktionsmitteln beim PVD- und (PA)CVD -Beschichten keine konstruktiven Veränderungen erfordert.

Die maximale Beschichtungstemperatur beträgt vorzugsweise 250°C, sodass bei einem Beschichtungsvorgang das Grundmaterial nicht angelassen wird.

Die Beschichtung wird vorzugsweise mit einer Dicke von etwa 0,5 µm bis etwa 10,0 µm, vorzugsweise 2,0 µm, ausgebildet. Dadurch ändern sich die Abmessungen und Oberflächenrauheiten des Grundkörpers in einem derart geringen Maße, dass keine Nachbearbeitung notwendig ist.

Im Folgenden wird eine weitere vorteilhafte Verwendung der erfindungsgemäßen Beschichtung näher erläutert. Fig. 3 illustriert eine perspektivische Ansicht eines hydraulischen Abstützelementes 8, welches einen Kolben 9 und ein Gehäuse 10 aufweist. Das hydraulische Abstützelement 8 ist mit einem Schlepphebel 11 gekoppelt, wobei der Schlepphebel 11 über ein Wälzlager 12 schwenkbar gelagert ist. Wie in Fig. 3 ferner ersichtlich ist, weist der Kolben 9 einen Kontaktbereich 90 zwischen dem Kolben 9 und dem Schlepphebel 11 auf. Ferner weist der Kolben 9 einen Kontaktbereich 91 zwischen dem Kolben 9 und dem Gehäuse 10 auf. Für eine Reduzierung des Verschleißes im Kontaktbereich 90 zwischen dem Kolben 9 und dem Schlepphebel 11 wird der Kontaktbereich 90 ebenfalls mit einer erfindungsgemäßen Funktionsschicht 4, entweder mit einer Schichtenfolge dünner unterschiedlicher Schichten oder mit einer eher dickeren Schicht mit senkrecht zur Oberfläche gleitend sich ändernden Parametern versehen.

Ferner kann ebenfalls der Kontaktbereich 91 zwischen dem Kolben 9 und dem Gehäuse 10 mit einer derartigen Beschichtung 3, 4 je nach Anwendung und Fertigungstechnologie beschichtet werden. Dadurch wird die Gesamtlebensdauer des dargestellten tribologischen Systems erhöht, wodurch ein Ausfall der einzelnen Maschinenteile während eines Betriebes reduziert und somit insgesamt Kosten eingespart werden können.

Außerdem können Komponenten des Wälzlagers 12, beispielsweise die Wälzkörper, die Innen- und Außenringe des Wälzlagers 12, die Wälzlagerkäfige, die Axialscheiben oder dergleichen ebenfalls zur Erhöhung der Korrosionsfestigkeit und des Verschleißwiderstandes und zur Reibungsreduzierung mit der erfindungsgemäßen Funktionsschicht 4 unter Zwischenschaltung beispielsweise einer Stütz- und/oder Haftvermittlungsschicht 3 beschichtet werden.

Das oben beschriebene Schichtsystem ist selbstverständlich auch für andere Bau- und Funktionseinheiten, wie beispielsweise Ventilschäfte bzw. Ventilschaftauflagen, Abstütz- und Einsteckelemente, Wälzlagerkomponenten, Ausrücklager, Kolbenbolzen, Lagerbuchsen, Steuerkolben für beispielsweise Einspritzdüsen im Motorenbereich, Linearführungen und andere mechanisch und tribologisch hoch beanspruchte Teile geeignet.

Es sei an dieser Stelle darauf hingewiesen, dass die Funktionsschicht 4 auch direkt auf dem Grundkörper des zu beschichtenden Maschinenteils abgeschieden werden kann, ohne dass eine Stützschicht 3 bzw. Haftvermittlungsschicht 3 dazwischen aufgebracht ist.

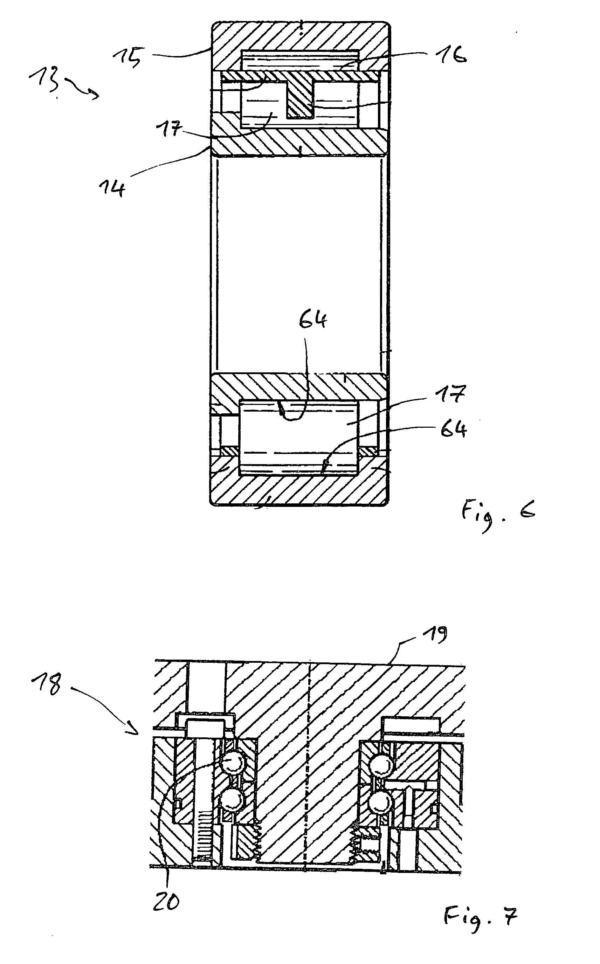

Die Figur 6 zeigt als spezielle Ausführungsform eines Wälzlagers 12 ein Zylinderrollenlager 13, welches mehrere Komponenten, nämlich einen Innenring 14, einen Außenring 15, sowie eine Anzahl in einem Käfig 16 geführter Zylinderrollen 17 umfasst. Mindestens eine der Komponenten 14, 15, 16, 17 weist eine Oberfläche 64 auf, die durch einen in Figur 5 wiedergegebnen Schichtaufbau gebildet ist. Das Zylinderrollenlager 13 ist beispielsweise in einer Windkraftanlage eingebaut

Beim in Figur 7 dargestellten Ausführungsbeispiel eines Wälzlagers 12 handelt es sich um ein zweireihiges Schrägkugellager 18, welches insbesondere zur Lagerung eines Drehtisches 19 einer Werkzeugmaschine geeignet ist. Als Wälzkörper sind in diesem Fall Kugeln 20 vorgesehen. Hinsichtlich der Beschichtung von Komponenten des Schrägkugellagers 18 gelten die Ausführungen zu Figur 6 analog.

Obwohl die vorliegende Erfindung anhand bevorzugter Ausführungsbeispiele vorstehend beschrieben wurde, ist sie darauf nicht beschränkt, sondern auf vielfältige Weise modifizierbar.

### Bezugszeichenliste

- 1: Maschinenteil
- 2: vorbestimmte Fläche des Maschinenteils
- 3: Stützschicht/Haftvermittlungsschicht
- 4: nanokristalline Funktionsschicht
- 5: Tassenstößel
- 6: Nocke
- 7: Ventilschaft
- 8: hydraulisches Abstützelement
- 9: Kolben
- 10: Gehäuse
- 11: Schlepphebel
- 12: Wälzlager
- 13: Zylinderrollenlager
- 14: Innenring
- 15: Außenring
- 16: Käfig
- 17: Zylinderrolle
- 18: Schrägkugellager
- 19: Drehtisch
- 20: Kugel
- 50: Nockenkontaktfläche
- 51: Tassenhemd
- 60, 61, 62, 63: Schichten
- 64: Oberfläche
- 90: Kontaktbereich zwischen Kolben und Schlepphebel
- 91: Kontaktbereich zwischen Kolben und Gehäuse

## Patentansprüche

1. Beschichtung für ein Bauteil mit einer auf amorphem Kohlenstoff basierenden und Wasserstoff enthaltenden Funktionsschicht, wobei die Funktionsschicht (4) eine Mehrzahl von Schichten (60, 61, 62, 63) enthält, die einen amorphen Kohlenstoff mit Wasserstoff aufweisen, die mit einem Nichtmetall dotiert sind und keine Metalldotierung aufweisen und von denen wenigstens eine Schicht dünner als 20 nm ist und die sich entweder in einem die Kristallbildung beeinflussenden Merkmal, nämlich dem Dotierungsgrad, dem Wasserstoffanteil, dem Anteil der sp3-hybridisierten Atome oder der Art der Dotierungsatome, unterscheiden oder zwischen denen jeweils wenigstens eine Schicht aus einem nicht mit einem Nichtmetall dotierten Kohlenstoff mit Wasserstoff liegt, **dadurch gekennzeichnet, dass** mehr als zehn Schichten (60, 61, 62, 63) vorgesehen sind.

2. Beschichtung nach Anpruch 1, **dadurch gekennzeichnet, dass** mehr als dreißig Schichten (60, 61, 62, 63) vorgesehen sind.

3. Beschichtung nach Anpruch 1 oder 2, **dadurch gekennzeichnet, dass** als Dotierungsatome der nichtmetalldotierten Schicht Fluor, Sauerstoff oder insbesondere Silizium dienen.

4. Beschichtung nach Anspruch 1 oder einem der folgenden, **dadurch gekennzeichnet, dass** in der Funktionsschicht wenigstens eine nichtmetalldotierte Schicht einer undotierten Schicht benachbart ist.

5. Beschichtung nach Anspruch 4, **dadurch gekennzeichnet, dass** in der Funktionsschicht zumindest bereichsweise abwechselnd nichtmetalldotierte und nicht mit einem Nichtmetall dotierte Schichten (60, 61, 62, 63) vorgesehen sind.

6. Beschichtung nach Anspruch 5, **dadurch gekennzeichnet, dass** mindestens fünf, insbesondere zehn, insbesondere zwanzig nicht mit einem Nichtmetall dotierte und nichtmetalldotierte Schichten (60, 61, 62, 63) abwechselnd vorgesehen sind.

7. Beschichtung nach Anspruch 1 oder einem der folgenden, **dadurch gekennzeichnet, dass** wenigstens eine der nichtmetalldotierten Schichten (60, 61, 62, 63) einen Gradienten der Dotierungsdichte senkrecht zur Oberfläche aufweist.

8. Beschichtung nach Anspruch 7, **dadurch gekennzeichnet, dass** der Gradient so gerichtet ist, dass der Nichtmetallanteil zur Oberfläche (64) der Funktionsschicht hin zunimmt.

9. Beschichtung nach einem der Ansprüche 1 bis 8, **dadurch gekennzeichnet, dass** unterhalb der Funktionsschicht (4) wenigstens eine Haftvermittlungsschicht (3), die im Wesentlichen aus Chrom, Wolfram oder Titan oder aus Boriden, Karbiden, Nitriden oder Siliziden der Übergangsmetalle besteht, vorgesehen ist.

10. Beschichtung nach einem der Ansprüche 1 bis 9, **dadurch gekennzeichnet, dass** unterhalb der Funktionsschicht (4) eine Stützschicht (3) aus einer Wasserstoff enthaltenden, metallhaltigen oder nichtmetallhaltigen Kohlenstoffschicht vorgesehen ist, die eine oder mehrere der Komponenten Wolfram, Tantal, Chrom, Vanadium, Hafnium, Titan, Nickel einerseits oder Silizium, Sauerstoff, Fluor, Stickstoff andererseits enthält.

11. Beschichtung nach Anspruch 1 oder einem der folgenden, **dadurch gekennzeichnet, dass** die Dicke der Funktionsschicht (4) zwischen 0,5 und 10 µm beträgt.

## Claims

1. Coating for a component with a functional layer based on amorphous carbon and containing hydrogen, wherein the functional layer (4) contains a plurality of layers (60, 61, 62, 63) which comprise an amorphous carbon with hydrogen, are doped with a non-metal and have no metal doping and of which at least one layer is thinner than 20 nm, and which either differ in a feature influencing the crystal formation, namely the degree of doping, the hydrogen fraction, the proportion of sp³-hybridized atoms or the type of doping atoms, or between which there respectively lies at least one layer of a carbon not doped with a non-metal, with hydrogen, **characterized in that** more than ten layers (60, 61, 62, 63) are provided.

2. Coating according to Claim 1, **characterized in that** more than thirty layers (60, 61, 62, 63) are provided.

3. Coating according to Claim 1 or 2, **characterized in that** flourine, oxygen or in particular silicon serve as doping atoms of the non-metal doped layer.

4. Coating according to Claim 1 or one of the following claims, **characterized in that**, in the functional layer, at least one non-metal-doped layer is neighbouring an undoped layer.

5. Coating according to Claim 4, **characterized in that**, in the functional layer, non-metal-doped layers and layers not doped with a non-metal (60, 61, 62, 63) are provided in an alternating manner, at least in certain regions.

6. Coating according to Claim 5, **characterized in that** at least five, in particular ten, in particular twenty, layers not doped with a non-metal and non-metal-doped layers (60, 61, 62, 63) are provided in an alternating manner.

7. Coating according to Claim 1 or one of the following claims, **characterized in that** at least one of the non-metal-doped layers (60, 61, 62, 63) has a gradient of the doping density perpendicular to the surface.

8. Coating according to Claim 7, **characterized in that** the gradient is directed such that the non-metal fraction increases toward the surface (64) of the functional layer.

9. Coating according to one of Claims 1 to 8, **characterized in that** at least one adhesion-promoting layer (3), which consists substantially of chromium, tungsten or titanium or of borides, carbides, nitrides or silicides of the transition metals, is provided below the functional layer (4).

10. Coating according to one of Claims 1 to 9, **characterized in that** a supporting layer (3) of a metal-containing or non-metal-containing carbon layer containing hydrogen, which contains one or more of the components tungsten, tantalum, chromium, vanadium, hafnium, titanium or nickel or silicon, oxygen, fluorine or nitrogen, is provided below the functional layer (4).

11. Coating according to Claim 1 or one of the following claims, **characterized in that** the thickness of the functional layer (4) is between 0.5 and 10 µm.

## Revendications

1. Revêtement de composant, le revêtement présentant une couche fonctionnelle à base de carbone et contenant de l'hydrogène,
la couche fonctionnelle (4) contenant plusieurs strates (60, 61, 62, 63) qui présentent un carbone amorphe et de l'hydrogène, qui sont dopées en un non-métal, qui ne présentent pas de dopage métallique, dont au moins l'une a une épaisseur inférieure à 20 nm, qui se distinguent par une caractéristique qui intervient dans la cristallisation, à savoir le degré de dopage, la teneur en hydrogène ou la teneur en atomes à hybridation sp3, ou par la nature des atomes de dopage, ou entre lesquelles est située au moins une strate en carbone non dopé en non-métal et contenant de l'hydrogène,
**caractérisé en ce que**
il présente plus de dix strates (60, 61, 62, 63).

2. Revêtement selon la revendication 1, **caractérisé en ce qu'**il présente de trente strates (60, 61, 62, 63).

3. Revêtement selon les revendications 1 ou 2, **caractérisé en ce que** le fluor, l'oxygène et en particulier le silicium servent d'atomes de dopage de la strate dopée en non-métal.

4. Revêtement selon la revendication 1 ou l'une des suivantes, **caractérisé en ce qu'**au moins une strate dopée en non-métal est voisine d'une strate non dopée.

5. Revêtement selon la revendication 4, **caractérisé en ce que** des strates dopées en non-métal et des strates (60, 61, 62, 63) non dopées en non-métal sont prévues en alternance dans au moins certaines parties de la couche fonctionnelle.

6. Revêtement selon la revendication 5, **caractérisé en ce qu'**au moins cinq, notamment dix et en particulier vingt strates non dopées en non-métal et strates (60, 61, 62, 63) dopées en non-métal sont prévues en alternance.

7. Revêtement selon la revendication 1 ou l'une des suivantes, **caractérisé en ce qu'**au moins l'une des strates (60, 61, 62, 63) dopées en non-métal présente un gradient de densité de dopage perpendiculairement à sa surface.

8. Revêtement selon la revendication 7, **caractérisé en ce que** le gradient est orienté de telle sorte que la teneur en non-métal augmente en direction de la surface (64) de la couche fonctionnelle.

9. Revêtement selon l'une des revendications 1 à 8, **caractérisé en ce qu'**au moins une couche (3) de renforcement de l'adhérence essentiellement constituée de chrome, de tungstène, de titane ou de borure, carbure, nitrure ou siliciure des métaux de transition est prévue en dessous de la couche fonctionnelle (4).

10. Revêtement selon l'une des revendications 1 à 9, **caractérisé en ce qu'**une couche de soutien (3) constituée d'une couche de carbone contenant de l'hydrogène, contenant du métal ou contenant du non-métal et qui contient d'une part un ou plusieurs des composants tungstène, tantale, chrome, vanadium, hafnium, titane, nickel et d'autre part silicium, oxygène, fluor et azote est prévue en dessous de la couche fonctionnelle (4).

11. Revêtement selon la revendication 1 ou l'une des suivantes, **caractérisé en ce que** l'épaisseur de la couche fonctionnelle (4) est comprise entre 0,5 et 10 µm.
